(19) Europäisches Patentamt
European Patent Office
Office européen des brevets

(11) **EP 1 429 992 B1**

(12) **EUROPEAN PATENT SPECIFICATION**

(45) Date of publication and mention
of the grant of the patent:
**08.11.2006 Bulletin 2006/45**

(51) Int Cl.:
***B81B 3/00*** (2006.01)

(21) Application number: **02776885.2**

(22) Date of filing: **06.09.2002**

(86) International application number:
**PCT/DK2002/000582**

(87) International publication number:
**WO 2003/022731 (20.03.2003 Gazette 2003/12)**

(54) **Flexible structure with integrated sensor/actuator**

Flexible Konstruktion mit integriertem Sensor/stellglied

Structure souple a détecteur/actionneur intègre

(84) Designated Contracting States:
**AT BE BG CH CY CZ DE DK EE ES FI FR GB GR IE IT LI LU MC NL PT SE SK TR**

(30) Priority: **07.09.2001 US 317488 P**
**10.12.2001 US 6582**

(43) Date of publication of application:
**23.06.2004 Bulletin 2004/26**

(73) Proprietor: **Danmarks Tekniske Universitet**
**2800 Kgs. Lyngby (DK)**

(72) Inventors:
• **THAYSEN, Jacob**
**DK-2200 Copenhagen N (DK)**
• **HANSEN, Ole**
**DK-2970 H rsholm (DK)**
• **MENON, Aric**
**DK-2900 Hellerup (DK)**
• **BOISEN, Anja**
**DK-2500 Valby (DK)**

(74) Representative: **Plougmann & Vingtoft A/S**
**Sundkrogsgade 9**
**P.O. Box 831**
**2100 Copenhagen OE (DK)**

(56) References cited:
**EP-A- 0 905 475      WO-A-00/66266**
**WO-A-90/03665      WO-A-94/28372**
**US-A- 6 087 638**

• **TORTONESE M ET AL: "Atomic force microscopy using a piezoresistive cantilever" TRANSDUCERS. SAN FRANCISCO, JUNE 24 - 27, 1991, PROCEEDINGS OF THE INTERNATIONAL CONFERENCE ON SOLID STATE SENSORS AND ACTUATORS, NEW YORK, IEEE, US, vol. CONF. 6, 24 June 1991 (1991-06-24), pages 448-451, XP010037386 ISBN: 0-87942-585-7**

**Description**

FIELD OF THE INVENTION

The present invention relates to a flexible structure comprising an integrated sensing/actuating element or elements. The integrated sensing/actuating elements are electrically accessible and at least partly encapsulated in a flexible and electrically insulating body so that the flexible structure may be operable in e.g. an electrically conducting environment.

BACKGROUND OF THE INVENTION

The use of e.g. SU-8 based (glycidyl ether of bisphenol A) polymers within the MEMS field has been exponentially growing during the last couple of years. SU-8 based polymers are known in the art as being an epoxy-based photosensitive polymer which may be used as a negative photoresist. SU-8 based photoresists are sensitive to light exposures in the near UV region - typically in the wavelength range from 365 nm to 436 nm. The fact that SU-8 based polymers are very chemically and thermally resistant makes it possible to use this group of polymers as component materials. Due to its capability of defining layers with thicknesses between 1 $\mu$m and 1 mm with high aspect ratios (>20), SU-8 based polymers have been a popular and cheap alternative to silicon for the fabrication of passive components. Such components include micro-channels, micro-molds for electroplating or masters for hot embossing. Passive SU-8 based atomic force microscopy (AFM) cantilevers have also been demonstrated.

WO 00/66266 discloses silicon-based micro-cantilever, micro-bridge or micro-membrane type sensors having piezo-resistive readout so as to form an integrated readout mechanism. Such micro-cantilevers, micro-bridges or micro-membrane sensors are suitable for use in micro-liquid handling systems so as to provide an integrated detection scheme for monitoring physical, chemical and biological properties of liquids handled in such-systems.

Since silicon 1) exhibits superior mechanical behavior and 2) has a very high piezo-resistive coefficient, silicon has been the obvious material when sensors with integrated readout were to be designed and fabricated.

However, in case silicon-based sensors with integrated readout are to be operated in a conducting liquid environment - such as in micro-liquid handling systems, encapsulation of the electronic circuit constituting the integrated readout is required - otherwise, the electronic circuit will short-circuit causing the integrated readout and thereby the sensor as a whole to fail to operate.

Furthermore, fabrication of silicon-based sensors is rather complicated due to the comprehensive process sequence required in order to fabricate such sensors. A consequence of the comprehensive process sequence is directly reflected in the fabrication costs causing the fabrication of silicon-based sensors to be very expensive.

US 6,087,638 discloses a thermal actuator comprising an inner conductive material encapsulated in a non-conductive expansive material, such as polytetraflouroethylene (PTFE) - see column 2, line 24. Preferably, the conductive material is formed as a corrugated copper heating element (see column 2, lines 23-24) so as to increase the rate of thermal transfer to the non-conductive expansive material encapsulating the copper heating element. The thermal actuator of US 6,087,638 is preferably applied in ink jet printers where ink is ejected through nozzles when the thermal actuator is activated.

It is evident that it is the non-conductive expansive material that causes the actuator of US 6,087,638 to deform/bend. This deformation/bending is induced by exposing the non-conductive material to heat via the thermal actuator which causes the non-conductive material to expand whereby the actuator as a whole is activated.

The fact that heat is what causes the actuator of US 6,087,638 to bend requires that a significant amount of power needs to be provided to the actuator. Even further, in case the actuator of US 6,087,638 is to be applied in micro-liquid handling systems, the heating of the actuator may cause the temperature of the surrounding liquid to increase which, in some situations, would be disadvantageous. In a worst case scenario, the increased temperature could initiate a chemical reaction in the liquid.

It is an object of the present invention to provide a solution to the above-mentioned disadvantages of conventional systems. Thus, it is an object of the present invention to provide a sensor/actuator configuration including an encapsulating and electrically insulating body so that the sensor/actuator may be immersed directly into a conducting liquid environment without the use of a separate encapsulation layer so as to avoid short-circuit of electronic components forming the integrated readout/integrated actuator. An advantage of such a sensor/actuator is that it can be operated in a conducting liquid environment without the use of the above-mentioned encapsulation layer.

It is a further object of the present invention to provide a sensor/actuator with integrated readout/actuator which is cheaper and easier to fabricate compared to conventional systems.

## SUMMARY OF THE INVENTION

The above-mentioned objects are complied with by providing, in a first aspect, a chip according to claim 1 for comprising a micro-cantilever for sensing deformations or performing actuation.

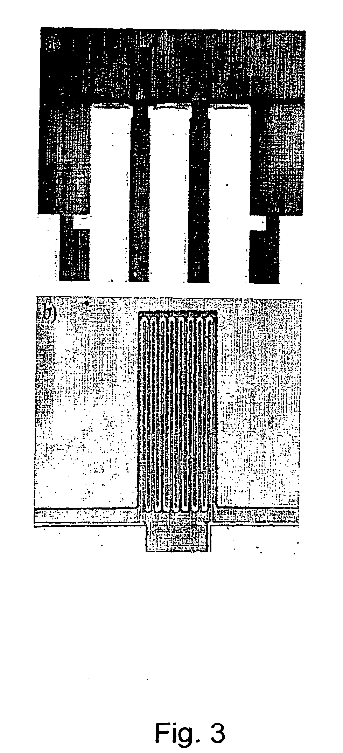

As specified by claim 1, the resistor formed in the micro-cantilever has a meander-like structure comprising longer first sections connected by shorter second sections. The sections are arranged so that the longer first sections extend in parallel along the length of the rectangular form of the micro-cantilever in a direction normal to the attachment section. This layout (which may be seen in the photograph shown in Figure 3) improves the bending sensibility and the actuator response.

The micro-cantilever may have a rectangular form. Typical dimensions of such micro-cantilever may be: width: 50-150 μm, length: approximately 200 μm, and thickness 1-10 μm.

A first and a second polymer layer may form the flexible polymer-based body where the integrated sensing means is embedded into the first and/or the second polymer layer.

The integrated resistor means (sensing element or elements) may be a resistor formed by a conducting layer - for example a metal layer such as a gold layer. The resistance of the resistor is dependent on deformations of the flexible structure whereby deformations of the flexible structures may be detected. Alternatively, the conducting layer may comprise a semiconductor material, such as silicon. If the semiconductor material is silicon, the resistor will be a so-called piezo-resistor which may be integrated in the polymer-based body using sputtering.

An SU-8 based polymer may form the flexible polymer-based body. Other suitable groups of photosensitive polymers are polyimide and BCB cydotene polymers. In case the polymer-based body is formed by two layers of polymers, these layers may both be SU-8 based, such as XP SU-8, polyimides or BCB cyclotene polymers or any combination thereof.

In the following, the present invention will be described in detail with reference to SU-8 based polymers only. However, this should not be regarded as a limitation with regard to choice of polymer material - polyimide and BCB cyclotene polymers could be used as well.

As already mentioned, SU-8 based polymers are known in the art as being an epoxy-based negative photoresist which are sensitive to light exposures in the near UV region (typically in the range 365 - 436 nm). SU-8 based polymers are characterized as being chemically and thermally stable which makes them attractive for device purposes.

The substantially rigid portion may be that part of a micro-cantilever, which is supported by a substrate. As well as the micro-cantilevers, the substantially rigid body may be formed by a first and a second polymer layer. The integrated electrical conductor may be at least partly embedded into the first and/or the second polymer layer. These polymer layers may be SU-8 based polymer layers, such as XP SU-8 polymer layers.

The integrated electrical conductor may be formed by a metal layer - for example a gold layer. Alternatively, the integrated electrical conductor may comprise a semiconductor material - for example sputtered silicon. The chip may further comprise at least three resistors, the at least three resistors forming part of the substantially rigid portion of the chip. The at least three resistors may be embedded into the first and/or the second polymer layer of the substantially rigid portion. In a preferred embodiment the chip comprises three resistors.

The present invention also relates to a chip comprising two or more micro-cantilevers according to the first aspect, said chip further comprising additional resistors on a substantially rigid portion of the chip.

In one embodiment, the chip comprises two micro-cantilevers according to the first aspect, the chip further comprising a substantially rigid portion comprising integrated electrical conductors each being at least partly encapsulated in an electrically insulating body, a number of said integrated electrical conductors being connected to the integrated sensing means and being electrically accessible via contact terminals on an exterior surface part of the substantially rigid portion. The chip may further comprise two resistors, the two resistors forming part of the substantially rigid portion of the chip.

The substantially rigid portion may comprise a first and a second polymer layer, where the integrated electrical conductors and the two resistors are at least partly embedded into the first and the second polymer layer of the substantially rigid portion of the chip

Preferably, these four resistors are connected so as to form a Wheatstone Bridge in combination.

The substrate may be a polymer substrate, such as an SU-8 based polymer substrate, or, alternatively, the substrate may be e.g. a semiconductor material, a metal, glass, or a plastic substrate. A suitable semiconductor material is silicon.

The present invention further relates to a sensor for measuring the presence of a substance in a fluid. Such sensor may comprise a chip according to the first aspect. Such sensor could be a micro-cantilever type sensor having integrated readout. A closed micro-liquid handling system allows laminated flows of different liquids to flow in the channel without mixing, which opens up for a new type of experiments and which reduces noise related to the liquid movement. Neighbouring or very closely spaced micro-cantilevers, micro-bridges or micro-membranes can be exposed to different chemical environments at the same time by:

- Laminating the fluid flow vertically in the micro-channel into two or more streams, so that micro-cantilevers or micro-membranes on opposing sides of the micro-channel are immersed in different fluids, or so that a micro-cantilever, micro-bridge, or micro-membrane is exposed to two different fluids.

- Laminating the fluid flow horizontally in the micro-channel, so that micro-cantilevers or micro-bridges recessed to different levels in the micro-channel or micro-membranes placed at the top and at the bottom of the channel are exposed to different fluids.

In this way, changes in viscous drag, surface stress, temperature, or resonance properties of adjacent or closely spaced micro-cantilevers, micro-bridges or micro-membranes induced by their different fluid environments, can be compared.

Neighbouring or very closely spaced micro-cantilevers, micro-bridges or micro-membranes can be coated with different chemical or biological substances for immersing adjacent or neighbouring micro-cantilevers, micro-bridges or micro-membranes in different fluids.

In micro-cantilever based sensors, the liquid volume may be minimised in order to reduce the use of chemicals and in order to obtain a system which is easy to stabilise thermally.

In the first aspect, the present invention may relate to an actuator comprising integrated actuator means being electrically accessible and being at least partly encapsulated in a flexible and electrically insulating body, said integrated actuator means being adapted to deform upon accessing the integrated actuator means electrically, thereby inducing deformations of the flexible structure in accordance with deformations of the integrated actuator means.

The integrated actuator means (actuator element or elements) may comprise at least one metal layer. The flexible and electrically insulating body is a polymer-based body formed by for example an SU-8 based polymer. In one embodiment, two different metal layers may be slightly heated whereby actuation may be achieved via the bimorph effect due to different thermal expansions of the two metal layers.

The present invention further relates to a chip comprising an actuator according to the first aspect, further comprising a polymer-based substrate supporting a substantially rigid portion of the chip. The substrate may be formed in a photosensitive polymer, such as an SU-8 based polymer. Alternatively, the substrate may be a silicon-based substrate supporting the substantially rigid portion of the chip.

In a second aspect, the present invention relates to a method of manufacturing a chip in accordance with claim 20. Preferably, the at least one conductor on the first area is connected to at least one resistor on the second area.

The electrically insulating layers may be polymer layers - for example SU-8 based polymer layers. The conducting layers may be metal layers - for example gold layers.

The third layer may be a polymer-based layer, such as an SU-8 based layer. Alternatively, the third layer may be a silicon-based layer. The method may further comprise the steps of

- providing a sacrificial layer on a silicon wafer, upon which the first electrically insulating layer is provided, and

- removing the silicon wafer after providing and patterning of the third layer.

BRIEF DESCRIPTION OF THE DRAWINGS

The present invention will now be explained in further detail with reference to the accompanying figures, where

figure 1 shows a process sequence for the fabrication of a polymer-based cantilever - here an SU-8 based polymer body,

figure 2 shows an example of a complete chip design,

figure 3 shows optical images of cantilevers with integrated meander-type resistor, and

figure 4 shows the relative change in resistance as a function of the cantilever deflection.

DETAILED DESCRIPTION OF THE INVENTION

As previously mentioned, the flexible structure may be the movable part of a cantilever beam, the movable part of a micro-bridge, or the movable part of a diaphragm. A detailed description of the present invention will now be provided with reference to a polymer-based cantilever-like structure. This exemplification should, however, not be regarded as a limitation of the present invention to polymer-based cantilever-like structures.

In the following, the sensitivity of an SU-8 based cantilever with integrated piezo-resistive readout is compared to the sensitivity of a conventional piezo-resistive silicon cantilever. In this comparison the surface stress sensitivity is compared for the two different sensors.

When molecules bind to a surface of a cantilever, the surface stress $\sigma_s$ changes due to molecular Interactions. This stress change can then be detected by the integrated piezo-resistor. A simple expression for the sensitivity can be obtained by assuming that the cantilever consists of only one material and an infinitely thin resistor placed on top of the cantilever. The relative change in resistance can then be determined as:

$$\frac{\Delta R}{R} / \sigma_s = -K \cdot \frac{4}{h \cdot E}$$

where K is the gauge factor, $E$ is Young's modulus and h is the thickness of the cantilever.

Preferably, a thin gold film is used as the piezo-resistor. Gold has a low gauge factor ($K_{Au}$=2) compared to silicon ($K_{Si}$=140) and is therefore considered inferior to silicon as a piezo-resistive sensor material.

From the equation it is seen that the $K/E$ actually determines the stress sensitivity of the cantilever for the same thickness. Since SU-8 based polymers have a Young's modulus of 5 GPa and silicon has a Young's modulus of 180 GPa, the ratios become $(K/E)_{Si}$=0.8 GPa$^{-1}$ and $(K/E)_{SU-8/Au}$=0.4 GPa$^{-1}$, which is only a factor of 2 in sensitivity in favor of silicon. The sensitivity of an SU-8 based piezo-resistive cantilever can be further enhanced by integrating a piezo-resistor material with even higher gauge factor. For example, it is possible to integrate a sputtered silicon piezo-resistor with a gauge factor of about 20. In order to use Young's modulus for SU-8 in the $K/E$ relation, the stiffness of the piezo-resistor should be neglectable compared to the SU-8 cantilever. This can be achieved by reducing the thickness of the poly-silicon resistor which increases the noise significantly and thereby reduces the signal to noise ratio.

Preferably, an SU-8 based cantilever with integrated piezo-resistive readout is fabricated on a silicon substrate. The substrate is only used in order to be able to handle the chips during processing.

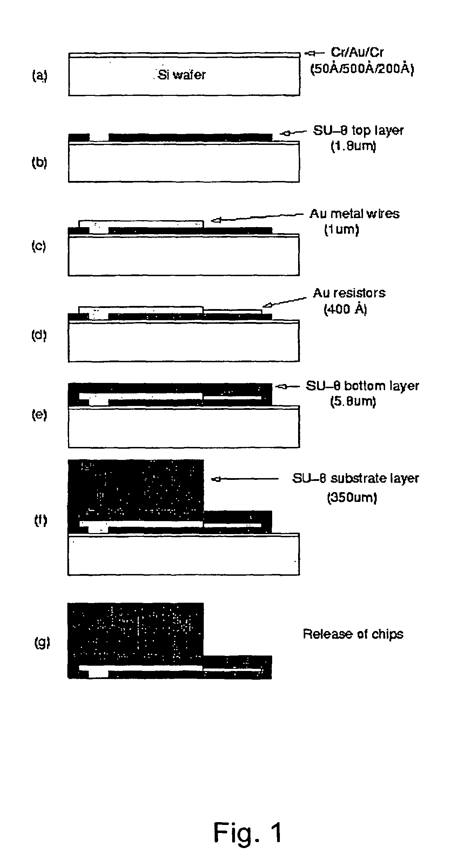

First, a Cr/Au/Cr layer is deposited on the silicon wafer as shown in figure 1a. This Cr/Au/Cr layer is used as a very fast etching sacrificial layer. A first layer of SU-8 is then provided, preferably by spinning, on the wafer and patterned as an upper cantilever layer - see figure 1b. The thickness of this layer is typically in the range of a few microns - for example in the range 1 - 5 μm. In figure 1b, the thickness of the first layer is 1,8 μm.

A gold layer with a thickness of approximately 1 μm is then deposited on top of the patterned thin SU-8 layer. A conductor is transferred to the SU-8 layer by standard photoresist/photolithography. This conductor is defined by etching - see figure 1c.

In figure 1d, another gold layer with a thickness of approximately 400 Å is deposited and a resistor is defined following the same procedure as described in connection with figure 1c.

The conductor and the resistor are encapsulated in SU-8 by depositing and patterning of a second SU-8 layer. This second polymer layer forms the lower part of the cantilever - see figure 1e. Preferably, the thickness of this second layer is within the range 3 - 10 μm. In figure 1e, the thickness of the second layer is 5,8 μm.

Finally, an SU-8 based polymer layer (approximately 350 μm thick) is spun on the second SU-8 layer and patterned as the chip substrate (figure 1f). The chip is finally released by etching of the sacrificial layer - see figure 1g.

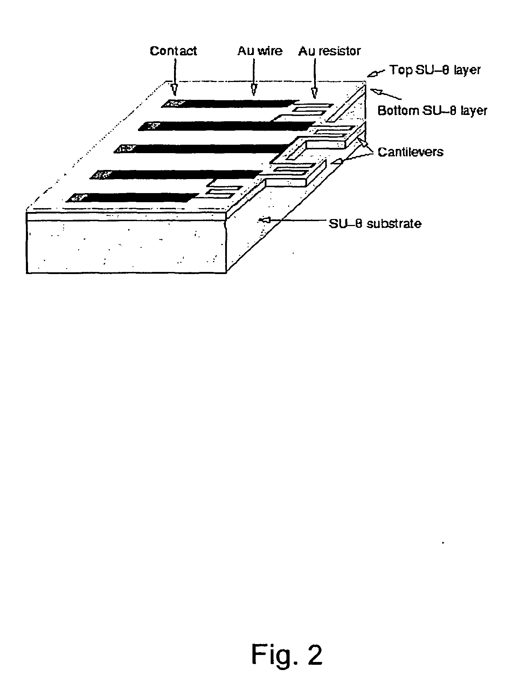

Figure 2 shows an SU-8 based cantilever chip design comprising two SU-8 cantilevers. As seen, the chip consists of two cantilevers with integrated gold resistors and two gold resistors on the substrate. The four resistors are connected via gold wires in such a way that in combination they form a Wheatstone bridge. The nodes of the Wheatstone bridge are accessible via the shown contact pads.

The advantage of the design shown in figure 2 is that one of the cantilevers may be used as a measurement cantilever, while the other cantilever may be used as a common-mode rejection filter. Typical parameters of the cantilevers shown in figure 2 are as follows:

Table 1: Typical design parameter:

| Parameter | Value | Unit |
|---|---|---|
| Cantilever length | 200 | μm |
| Cantilever width | 100 | μm |
| Cantilever Thickness | 7.3 | μm |
| Spring constant | 7 | N/m |
| Resonant frequency | 49 | kHz |

In figure 3, optical images of a fabricated chip are shown. In figure 3a, both cantilevers are seen. Figure 3b shows a close-up of one of the cantilevers. The meander-like resistor structure is clearly seen in the image.

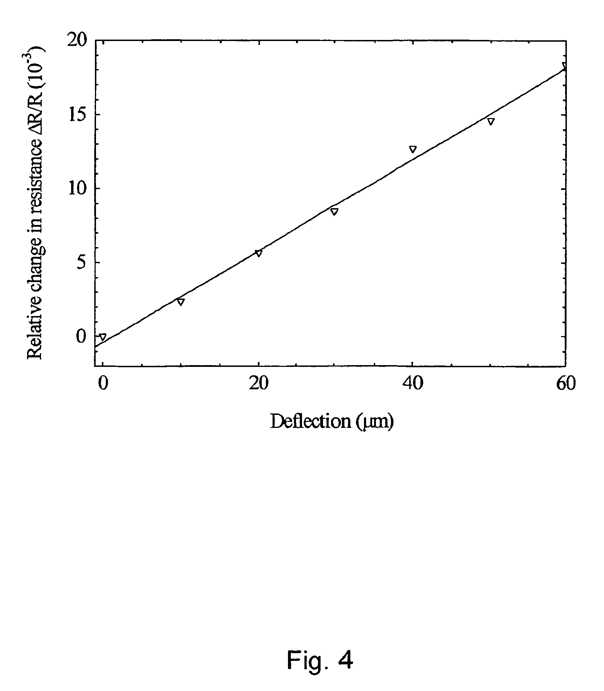

The deflection sensitivity of piezo-resistive SU-8 cantilevers has been measured by observing the relative change in resistance as a function of the cantilever deflection - the result is shown in figure 4. It is seen that a straight line can be obtained from the measurement, which indicates that the deformation is purely elastic.

From figure 4, the deflection sensitivity can be determined from the slope of the straight line to $\frac{\Delta R}{R}/z = 0.3 \text{ ppm/nm,}$ which yields a gauge factor of $K = 4$. The minimum detectable deflection or minimum detectable surface stress is given by the noise in the system. Since the vibrational noise is considerably lower than the electrical noise sources in the above-mentioned resistor setup, only the Johnson noise and the 1/f noise may be considered. The noise has been measured as a function of frequency for different input voltages. It was observed that the 1/f noise was very low with a knee frequency of about 10 Hz for a Wheatstone bridge supply voltage of 4.5 V.

Table 2: Performance of the SU-8 based piezo-resistive cantilever compared to a piezo-resistive silicon cantilever.

| Parameter | SU-8 cantilever | Si cantilever (optimized) |
|---|---|---|
| Deflection sensitivity [nm]$^{-1}$ | $0.3 \times 10^{-6}$ | $4.8 \times 10^{-6}$ |
| Minimum detectable deflection [Å] | 4 | 0.4 |
| Surface stress sensitivity [N/m]$^{-1}$ | $3 \times 10^{-4}$ | $1 \times 10^{-3}$ |
| Minimum detectable surface stress [N/m] | $1 \times 10^{-4}$ | $2 \times 10^{-5}$ |

From the above measurements it is possible to summarize the performance of the SU-8 based piezo-resistive cantilever - table 2.

With respect to deflection sensitivity, minimum detectable deflection, surface stress sensitivity and minimum detectable surface stress, the performance is compared to an optimized silicon piezo-resistive cantilever.

It is seen from table 2 that the minimum detectable deflection is 10 times better for the silicon cantilever, but only 5 times better regarding the minimum detectable surface stress. Thus, the SU-8 based piezo-resistive cantilever may e.g. be used as a surface stress bio-chemical sensor, since the change in surface stress due to molecular interactions on a cantilever surface is normally in the order of $10^{-3}$ -1 N/m.

Reducing the thickness of the cantilever can increase the surface stress performance even further. As seen from the previously show equation, the sensitivity is inversely proportional with the thickness. With the given technology it is possible to decrease the cantilever thickness with a factor of 2 and thereby decrease the minimum detectable surface stress with a factor of 2.

While the present Invention has been described with reference to a particular embodiment - micro-cantilevers, those skilled in the art will recognise that many changes may be made thereto without departing from the spirit and scope of the present invention. Such changes could be the appliance of the concept of the present invention to micro-bridges, micro-membrane or diaphragms or similar micro-mechanical structures.

For example, the principle of encapsulating a thin gold resistor into a compliant SU-8 structure can also be used for different kinds of sensors, such as stress sensitive micro-bridges or stress sensitive membranes for example used as pressure sensors or bio-sensors, such as micro-liquid handling systems.

In bio-sensors, measurements of the properties of fluids - especially liquids - flowing in microscopic channels is of importance. In such sensors, the following properties would be determinable using the present invention:

1) physical properties such as flow rates viscosity and local temperature,
2) chemical properties such as pH and chemical composition,
3) biological properties such as identification of organic constituents in fluids, including DNA fragments, proteins, and complete biological cells.

Micro-liquid handling systems typically consist of narrow channels of order 100 microns wide and 100 microns deep engraved or embossed into the surface of a thin wafer of a material such as silicon, glass, plastic or polymers using reproduction techniques based on micromachining. The surface containing the channels is usually bonded to another surface, in order to seal the channels. Fluids pumped through the resulting channels typically flow in a completely laminar fashion. As a result, several different fluids can be flowed in laminated streams through such microsystems, without any significant mixing of the fluids.

An important advantage of a micro-liquid handling system is that very small quantities of fluid can be directed in a controlled fashion to various parts of the system, where various analytical techniques can be used to determine the properties of the liquid. This can be done using external analytical techniques such as optical detection. The controlled flow of the fluid is achieved via pumps and valve systems that can be either external or integrated with the micro-channels.

A change in the mechanical properties of a micro-cantilever can for example be a stress formation in the micro-cantilever due to changes in surface stress of the micro-cantilever. Stress formation can also occur due to changes in temperature of the micro-cantilever due to a bimorph effect, if the micro-cantilever is made of two materials with different thermal expansion coeffidents. Such stress formations in the micro-cantilever can be detected as a change in the resistivity of a piezo-resistor embedded into the micro-cantilever body.

Change in resonance frequency is another example of a change in a mechanical property. A change in mass of the micro-cantilever can occur if material binds to the micro-cantilever, and such a change will produce a change in the resonance frequency of the micro-cantilever. Such changes can be monitored by actuating the micro-cantilever at a frequency near its resonance frequency, and monitoring changes in the amplitude of the resulting dynamic bending of the micro-cantilever, using the integrated sensing means as described above for the detection of stress formation.

In the following, examples of different applications of the present invention are listed and commented on. However, the application of the present invention should naturally not be limited to the listed examples.

In sensors supporting laminated flows, adjacent or very dosely spaced micro-cantilevers can be exposed to different chemical environments at the same time by

1) Laminating the fluid flow vertically in the micro-channel into two or more streams, so that micro-cantilevers on opposing sides of the micro-channel are immersed in different fluids.

2) Laminating the fluid flow horizontally in the micro-channel, so that micro-cantilevers recessed to different levels in the micro-channel are immersed in different fluids.

3) Laminating the fluid flow either horizontally or vertically and moving the micro-cantilevers through the different fluids by actuating the micro-cantilevers.

In case of laminated fluids, micro-cantilever signals from different fluidic environments can be compared. Moreover, the technology can be used for coating narrowly spaced micro-cantilevers with different chemical substances. Examples on both aspects will be described below.

Functionalisation of micro-cantilevers can be performed using conventional immobilisation chemistry, which easily applies to the micro-cantilever materials. However, for the closely spaced micro-cantilevers in micro-channels, new technologies for applying the different coatings are needed. The functionalisation of narrowly spaced micro-cantilevers can be performed by one or more of the technologies described below:

1) In the micro-fabrication of the device, the micro-cantilevers can be coated with different thin film layers which are compatible with the fabrication process. The thin films can be metal, silicon and dielectric layers. The different thin films can then be used to bind molecules which have a specific binding to a specific thin film.

2) The molecules to be attached on the micro-cantilever surface can be synthesised with a photo activated binding site. Molecules are then attached to the micro-cantilever surface by placing the micro-cantilever in a liquid solution with the coating molecules and exposing the micro-cantilever to UV light. The UV light induces the creation of a bond between the micro-cantilever surface and molecules. This coating can be performed in the channel after it has been closed, by injecting different coating molecules in the channel and illuminating the micro-cantilevers individually through the cover plate. By scanning a laser across the device, small well-defined areas can be coated with specific coatings. Between each coating the system must be rinsed and a new coating solution injected in the channels.

3) Using an inkjet printer principle, small droplets of liquid can be delivered. These systems are commercially available for DNA chip fabrication. Such a liquid delivery system can be used to spray droplets of different liquids on closely spaced micro-cantilevers. The delivered droplets typically have a diameter of 100 $\mu$m. This coating technique must be performed before the channel is sealed.

4) When the channels are sealed, laminated flow can be used to coat narrowly spaced micro-cantilevers by having two or more laminated flows in the system. Micro-cantilevers placed in different heights and/or on different sides of the channel will thus be immersed in different liquids.

After coating, the micro-channels can be flushed with other fluids to remove the residual coating material. By repeating the technique, several layers of coating can be added to the micro-cantilever. In order to bind molecules to only one side of the micro-cantilever, photoimmobilisation or pre-deposited thin films can be used.

5) Selective coating can be performed by laminating two or more streams in the micro-channel and placing the micro-cantilever in one of the streams by a static bending. Moreover, a controlled movement of the micro-cantilever through separated laminated streams can be used to coat the micro-cantilever with multiple layers such as glutaraldehyde-avidin-biotin.

6) Selective and reversible coating of the micro-cantilever, with for example metalloproteins, can be achieved electrochemically. A conducting layer on the micro-cantilever can be used as the working electrode. The counter electrode might be an integrated part of the system. Also it is often desirable to include a reference electrode for control of the applied potential.

To minimise the effect of turbulence and thermal drift in a sensor system, a reference micro-cantilever can be introduced. The reference micro-cantilever is placed close to the measurement micro-cantilever and in the same measurement environment. However, the reference micro-cantilever is not coated with a detector film. The reference micro-cantilever might be coated with another film which does not act as a detector or which detects a second substance. By subtracting the reference signal from the measurement signal, most background noise can be eliminated.

For most biochemical applications it is important to perform a reference measurement in a reference liquid. Often it is the increase/decrease in the concentration of a specific molecule which is of interest. For such relative measurements, a reference liquid is required. The micro-cantilever placed in the reference solution should be identical to the measurement micro-cantilever in the measurement solution. The measurement solution and the reference solution can be investigated in the same channel at the same time by laminating the flow and letting the two streams run in parallel. Micro-cantilevers placed on either side of the channel will measure the reaction in two different fluids. Quasi-simultaneous measurements in analytes and in reference solutions can be performed by moving the micro-cantilever through the two liquids.

Molecules which bind to the detector films on the micro-cantilever change the stress of the film, which results in a micro-cantilever bending. For example, diffusion in cell micro-membranes can be investigated and the activity of specific micro-membrane channels which are regulated by voltage or by the binding of another molecule can be investigated. Time-dependent response from micro-cantilevers can be used to investigate the dynamics of layer formation on the micro-cantilever surface. For example the formation of self-assembled monolayers can be investigated.

Conformal changes of proteins adsorbed on a micro-cantilever will give rise to a change in resonance frequency and stress of the micro-cantilever. Hereby, it is possible to study the conformal changes of proteins caused by external parameters such as pH-value, ion-concentration and temperature. For example, the metalloprotein azurin adsorbed on gold is known to undergo conformational changes when subjected to different pH-values. How azurin binds to gold, and how the binding is changed when the pH-value is changed is not well understood, and the micro-cantilever-based measurements can give additional information on the binding properties. Many active enzyme functions also result in stress changes. Thereby enzyme activity levels in different environments can be investigated.

One of the major applications of the invention is the detection of multiple disease-associated genes. Single stranded DNA from the disease-associated genes is attached to micro-cantilevers by one of the coating technologies described above using conventional binding chemistry. Narrowly spaced micro-cantilevers placed in one channel can be coated with DNA sequences from different genes. A treated blood sample consisting of single stranded DNA is then flushed through the system. If one of the disease-associated genes is present in the sample, it will bind specifically to the corresponding DNA string attached to the micro-cantilever. DNA strings, which have been non-speafically bounded, can be detached by a heat treatment. The specific binding will result in a surface stress change as well as in a resonance change of the micro-cantilever. Hereby it is possible to perform a screening of several genes simultaneously. The method could also apply to DNA sequencing.

The idea of screening for specific genes can be expanded to the detection of different antibodies. For this application closely spaced micro-cantilevers are coated with different antigens, using conventional binding chemistries. Antibodies bind specifically to antigens, whereby it is possible to screen for different antibodies in a blood sample.

Applying a conducting layer on the micro-cantilever and a reference electrode in the channel it is possible to perform electrodeposition and electrochemistry on layers on a micro-cantilever surface. For example in can be investigated how the stress in layers of metalloproteins such as azurin and yeast cytochrome c respond to different potentials. Furthermore, redox-processes might be monitored. Moreover, the adsorption and desorption of electrodepositable molecules can be investigated.

Furthermore, actuation of a compliant SU-8 based actuator structure can be realised by depositing on or encapsulating a thin gold film into the SU-8 based material. Using the fact that the gold and the SU-8 based material have different thermal expansion, the compliant SU-8 based actuator structure may be actuated due to the bimorph effect. For example, by integrating two gold films into the same compliant SU-8 based structure, such that the two gold films form a plate capacitor, both a sensor and an actuator based on the electrostatic (capacitive) principle can be obtained.

The compliant SU-8 based structure can also be bonded, glued or welled on pre-defined structures or substrates other than SU-8 - for example, plastic, silicon, glass, or metals can be applied. Similarly, other realisations of sensors and actuators can involve the use of other polymers than SU-8 based polymers and other metals than gold.

Each of these embodiments and obvious variations thereof is contemplated as falling within the spirit and scope of the claimed invention, which is set forth in the following claims.

## Claims

1. A chip comprising a micro-cantilever for sensing deformations or performing actuation, the miao-cantilever having a rectangular form with one side being an attachment section, the mlao-cantilever comprising Integrated resistor means being encapsulated In a flexible and electrically Insulating polymer based body, said integrated resistor means further being adapted to sense or induce deformations of the micro-cantilever,
the chip further comprising a substantially rigid portion comprising an integrated pair of wires being at least partly encapsulated in an electrically insulating body, the attachment section of the micro-cantilever being attached to the substantially rigid portion so that said integrated pair of wires is connected to the integrated resistor means and is electrically accessible via a contact terminal on an exterior surface part of the substantially rigid portion, the chip being **characterized in that** the polymer is a photosensitive polymer, and **in that** said integrated resistor means has a meander-like structure comprising longer first sections connected by shorter second sections, the longer first sections extending in parallel along the length of the rectangular form of the micro-cantilever in a direction normal to the attachment section.

2. A chip according to claim 1, wherein the photosensitive polymer is selected from the group consisting of: SU-8 based polymers, such as an XP SU-8 polymer, polyimides or BCB cydotene polymers.

3. A chip according to claim 2, wherein the flexible polymer-based body comprises a first and a second polymer layer, the first and second polymer layers being arranged in a sandwich structure.

4. A chip according to claim 3, wherein the integrated resistor means is at least partly embedded between the first and the second polymer layer.

5. A chip according to any of the preceding claims, wherein the Integrated resistor means comprises more than one resistor the resistance of the more than one resistor being dependent on deformations of the flexible structure.

6. A chip according to claim 5, wherein the more than one resistor is defined by a semiconductor material, such as silicon.

7. A chip according to claim 1, wherein the substantially rigid portion comprises a first and a second polymer layer, and wherein the integrated electrical conductor is at least partly embedded between the first and the second polymer layer of the substantially rigid portion.

8. A chip according to claim 7, wherein the polymer layers of the substantially rigid portion are formed In photosensitive polymer layers, the photosensitive polymer being selected from the group consisting of: SU-8 based polymers, such as an XP SU-8 polymer, polyimides or BCB cyclotene polymers.

9. A chip according to claims 7 or 8, wherein the integrated electrical conductor comprises a semiconductor material, such as silicon.

10. A chip according to any of claims 7 - 9, further comprising at least three resistors, the at least three resistors forming part of the substantially rigid portion of the chip.

11. A chip according to claim 10, comprising three resistors.

12. A chip according to claim 11, wherein the three resistors are at least partly embedded between the first and the second polymer layer of the substantially rigid portion.

13. A chip comprising two flexible structures according to any of claims 5 or 6, the chip further comprising a substantially rigid portion comprising integrated electrical conductors each being at least partly encapsulated in an electrically insulating body, a number of said integrated electrical conductors being connected to the integrated sensing means and being electrically accessible via contact terminals on an exterior surface part of the substantially rigid portion.

**14.** A chip according to claim 13, further comprising two resistors, the two resistors forming part of the substantially rigid portion of the chip.

**15.** A chip according to claim 14, wherein the substantially rigid portion comprises a first and a second polymer layer, and wherein the integrated electrical conductors and the two resistors are at least partly embedded between the first and the second polymer layer of the substantially rigid portion of the chip.

**16.** A chip according to claims 14 or 15, wherein the two flexible structures each comprises one resistor and where the substantially rigid portion of the chip comprises two resistors so that the chip comprises a total of four resistors, and where the four resistors are connected so as to form a Wheatstone Bridge.

**17.** A chip according to any of claims 7 - 16, further comprising a polymer-based substrate supporting the substantially rigid portion of the chip.

**18.** A chip according to claim 17, wherein the substrate is formed in a photosensitive polymer, the photosensitive polymer being selected from the group consisting of: SU-8 based polymers, such as an XP SU-8 polymer, polyimides or BCB cyclotene polymers.

**19.** A chip according to any of claims 7 - 16, further comprising a silicon-based substrate supporting the substantially rigid portion of the chip.

**20.** A method of manufacturing a chip, the method comprising the steps of

- providing a first electrically insulating layer,
- patterning the first electrically insulating layer so as to form a first area and a different second area, where the second area forms a first part of a flexible cantilever having a rectangular form, at least one side of the rectangular form being an attachment section attaching the second area to the first area,
- providing, onto the first area of the layer, a first conducting layer, and patterning the first conducting layer so as to form a pair of wires on the first area of the patterned first electrically insulating layer,
- providing, onto the second area, a second conducting layer, and patterning the second conducting layer so as to form at least one resistor on the second area of the patterned first electrically insulating layer where the pair of wires is electrically connected to the at least one resistor, and
- providing, onto the first and second areas of the first electrically insulating layer, a second electrically insulating layer so as to at least partly encapsulate the pair of wires and the at least one resistor, and thereby forming a second part of the flexible cantilever,

**characterized in that** the resistor being an elongated meander-like structure comprising longer first sections connected by shorter second sections, the longer first sections being arranged in parallel along the length of the rectangular form of the flexible cantilever in a direction normal to the attachment section, and **in that** the method further comprises the steps of providing a third layer onto the second electrically insulating layer, and patterning the third layer so as to form a substrate that only supports the first area of the second electrically insulating layer.

**21.** A method according to claim 20, wherein at least one conductor on the first area is connected to at least one resistor on the second area.

**22.** A method according to claims 20 or 21, wherein the electrically insulating layers are polymer layers.

**23.** A method according to claim 22, wherein the polymer layers are formed in photosensitive polymer layers, the photosensitive polymer being selected from the group consisting of: SU-8 based polymers, such as an XP SU-8 polymer, polyimides or BCB cyclotene polymers.

**24.** A method according to claim 20, wherein the third layer is formed in a photosensitive polymer layer, the photosensitive polymer being selected from the group consisting of: SU-8 based polymers, such as an XP SU-8 polymer, polyimides or BCB cyclotene polymers.

**25.** A method according to claim 20, wherein the third layer is a silicon-based layer.

**26.** A method according to claim 20, further comprising the steps of

- providing a sacrificial layer on a silicon wafer, upon which the first electrically insulating layer is provided, and
- removing the silicon wafer after providing and patterning of the third layer.

**Patentansprüche**

1. Chip, umfassend eine Mikrospitze zur Abtastung von Deformationen oder zum Bereitstellen, wobei die Mikrospitze mit einer Seite, die ein Befestigungsabschnitt ist, eine rechteckige Form hat, wobei die Mikrospitze integrierte, in einem flexiblen und elektrisch isolierten polymerbasierten Körper eingekapselte, Widerstandsmittel umfasst, wobei die integrierten Widerstandsmittel ferner zur Abtastung oder Erzeugung von Deformationen der Mikrospitze eingerichtet sind,
wobei der Chip ferner einen im Wesentlichen steifen Abschnitt umfasst, der ein integriertes Paar von mindestens teilweise in einem elektrisch isolierten Körper eingekapselten Kabeln umfasst, wobei der Befestigungsabschnitt der Mikrospitze am im Wesentlichen steifen Abschnitt so befestigt ist, dass das integrierte Kabelpaar mit den integrierten Widerstandsmitteln verbunden und via eines Kontaktanschlusses an einem äusseren Oberflächenteil des im Wesentlichen steifen Abschnitts zugänglich ist,
wobei der Chip **dadurch gekennzeichnet ist, dass** das Polymer ein photosensitives Polymer ist, und dass die integrierten Widerstandsmittel eine mäanderähnliche Struktur habem, die längere erste, durch kürzere zweite Abschnitte verbundene, Abschnitte umfasst, wobei sich die längeren ersten Abschnitte parallel entlang der Länge der rechteckigen Form der Mikrospitze in einer zum Befestigungsabschnitt normalen Richtung erstrecken.

2. Chip nach Anspruch 1, worin das photosensitive Polymer aus der Gruppe bestehend aus: SU-8-basierten Polymeren, wie zum Beispiel einem XP SU-8-Polymer, Polyimiden oder BCB-Zykloten-Polymeren, ausgewählt ist.

3. Chip nach Anspruch 2, worin der flexible polymerbasierte Körper eine erste und eine zweite Polymerschicht umfasst, wobei die ersten und zweiten Polymerschichten in einer Sandwich-Struktur angeordnet sind.

4. Chip nach Anspruch 3, worin die integrierten Widerstandsmittel zumindest teilweise zwischen der ersten und der zweiten Polymerschicht eingebettet sind.

5. Chip nach irgendeinem der vorhergehenden Ansprüche, worin die integrierten Widerstandsmittel mehr als einen Widerstand aufweisen, wobei der Widerstand von mehr als einem Widerstand von Deformationen der flexiblen Struktur abhängig sind.

6. Chip nach Anspruch 5, worin der mehr als eine Widerstand durch ein Semileitermaterial, wie Silicium, definiert ist.

7. Chip nach Anspruch 1, worin der im Wesentlichen steife Abschnitt eine erste und eine zweite Polymerschicht aufweist, und worin der integrierte elektrische Leiter zumindest teilweise zwischen der ersten und der zweiten Polymerschicht des im Wesentlichen steifen Abschnitts eingebettet ist.

8. Chip nach Anspruch 7, worin die Polymerschichten des im Wesentlichen steifen Abschnitts in photosensitiven Polymerschichten geformt sind, wobei das photosensitive Polymer aus der Gruppe bestehend aus: SU-8-basierten Polymeren, wie zum Beispiel einem XP SU-8-Polymer, Polyimiden oder BCB-Zykloten-Polymeren, gewählt ist.

9. Chip nach den Ansprüchen 7 oder 8, worin der integrierte elektische Leiter ein Semileitermaterial, wie Silicium, aufweist.

10. Chip nach irgendeinem der Ansprüche 7 - 9, ferner umfassend mindestens drei Widerstände, wobei die mindestens drei Widerstände einen Teil des im Wesentlichen steifen Abschnitts des Chips bilden.

11. Chip nach Anspruch 10, umfassend drei Widerstände.

12. Chip nach Anspruch 11, worin die drei Widerstände zumindest teilweise zwischen der ersten und der zweiten Polymerschicht des im Wesentlichen steifen Abschnitts eingebettet sind.

13. Chip, umfassend zwei flexible Strukturen nach irgendeinem der Ansprüche 5 oder 6, wobei der Chip weiterhin einen im Wesentlichen steifen Abschnitt aufweist, der integrierte elektrische Leiter aufweist, die jeweils zumindest teilweise in einem elektrisch isolierten Körper eingekapselt sind, wobei eine Anzahl der integrierten elektrischen Leiter mit den integrierten Abtastmitteln verbunden und via Kontaktanschlüsse an einem äusseren Oberflächenteil des im Wesentlichen steifen Abschnitts elektrisch zugänglich ist.

14. Chip nach Anspruch 13, ferner umfassend zwei Widerstände, wobei die beiden Widerstände einen Teil des im Wesentlichen steifen Abschnitts des Chips bilden.

15. Chip nach Anspruch 14, worin der im Wesentlichen steife Abschnitt eine erste und eine zweite Polymerschicht aufweist, und worin die integrierten elektrischen Leiter und die beiden Widerstände zumindest teilweise zwischen der ersten und der zweiten Polymerschicht des im Wesentlichen steifen Abschnitts des Chips eingebettet sind.

16. Chip nach den Ansprüchen 14 oder 15, worin die beiden flexiblen Strukturen jeweils einen Widerstand aufweisen, und wobei der im Wesentlichen steife Abschnitt des Chips zwei Widerstände aufweist, so dass der Chip insgesamt vier Widerstände aufweist, und wobei die vier Widerstände so verbunden sind, um eine Wheatstone-Brücke zu bilden.

17. Chip nach irgendeinem der Ansprüche 7 - 16, ferner umfassend ein polymerbasiertes Substrat, das den im Wesentlichen festen Abschnitt des Chips unterstützt.

18. Chip nach Anspruch 17, worin das Substrat in einem photosensitiven Polymer gebildet ist, wobei das photosensitive Polymer aus der Gruppe bestehend aus: SU-8-basierten Polymeren, wie z.B. einem XP SU-8-Polymer, Polyimiden oder BCB-Zykloten-Polymeren, gewählt ist.

19. Chip nach irgendeinem der Ansprüche 7 - 16, ferner umfassend ein Siliciumbasiertes Substrat, das den im Wesentlichen festen Abschnitt des Chips unterstützt.

20. Verfahren zur Herstellung eines Chips, das die Schritte umfasst

   - Bereitstellung einer ersten elektrisch isolierten Schicht,
   - Musterung der ersten elektrisch isolierten Schicht, um ein erstes Gebiet und ein andersartiges zweites Gebiet zu bilden, wobei das zweite Gebiet einen ersten Teil einer flexiblen Spitze mit einer rechteckigen Form bildet, wobei mindestens eine Seite der rechteckigen Form ein Befestigungsabschnitt ist, der das zweite Gebiet am ersten Gebiet befestigt,
   - Bereitstellung einer ersten leitenden Schicht auf dem ersten Gebiet der Schicht, und Musterung der ersten leitenden Schicht, um ein Kabelpaar am ersten Gebiet der gemusterten ersten elektrisch isolierten Schicht zu bilden,
   - Bereitstellung einer zweiten leitenden Schicht auf dem zweiten Gebiet, und Musterung der zweiten leitenden Schicht, um mindestens einen Widerstand am zweiten Gebiet der gemusterten ersten elektrisch isolierten Schicht zu bilden,

   wobei das Kabelpaar mit dem zumindest einen Widerstand elektrisch verbunden ist, und

   - Bereitstellung einer zweiten elektrisch isolierten Schicht auf den ersten und zweiten Gebieten der ersten elektrisch isolierten Schicht, um zumindest teilweise das Kabelpaar und mindestens einen Widerstand einzukapseln, und dabei ein zweiter Teil der flexiblen Spitze gebildet wird,

   **dadurch gekennzeichnet, dass** der Widerstand eine längliche mäanderartige Struktur ist, die längere erste, durch kürzere zweite Abschnitte verbundene, Abschnitte aufweist, wobei die längeren ersten Abschnitte parallel entlang der Länge der rechteckigen Form der flexiblen Spitze in einer zum Befestigungsabschnitt normalen Richtung angeordnet sind, und dass das Verfahren ferner die Schritte zur Bereitstellung einer dritten Schicht auf der zweiten elektrisch isolierten Schicht umfasst, und Musterung der dritten Schicht, um ein Substat zu bilden, dass nur das erste Gebiet der zweiten elektrisch isolierten Schicht unterstützt.

21. Verfahren nach Anspruch 20, worin mindestens ein Leiter am ersten Gebiet mit mindestens einem Widerstand des zweiten Gebiets verbunden ist.

22. Verfahren nach den Ansprüchen 20 oder 21, worin die elektrisch isolierten Schichten Polymerschichten sind.

23. Verfahren nach Anspruch 22, worin die Polymerschichten in einem photosensitiven Polymer gebildet sind, wobei das photosensitive Polymer aus der Gruppe bestehend aus: SU-8 basierten Polymeren, wie z.B. einem XP SU-8-Polymer, Polyimiden oder BCB-Zykloten-Polymeren, ausgewählt ist.

24. Verfahren nach Anspruch 20, worin die dritte Schicht in einer photosensitiven Polymerschicht gebildet ist, wobei das photosensitive Polymer aus der Gruppe bestehend aus: SU-8-basierten Polymeren, wie z.B. ein XP SU-8-Polymer, Polyimiden oder BCB-Zyklotenpolymeren, gewählt ist.

25. Verfahren nach Anspruch 20, worin die dritte Schicht eine Silicium-basierte Schicht ist.

26. Verfahren nach Anspruch 20, ferner umfassend die Schritte

- Bereitstellung einer Opferschicht an einer Siliciumwafer, auf der die erste elektrisch isolierte Schicht bereitgestellt ist, und
- Entfernung der Siliciumscheibe nach der Bereitstellung und Musterung der dritten Schicht.

## Revendications

1. Puce comprenant un micro-cantilever pour détecter des déformations ou effectuer une commande, le micro-cantilever présentant une forme rectangulaire avec un côté étant une section de rattachement, et comprenant un moyen de résistance intégré étant encapsulé dans un corps flexible et à base de polymère électriquement isolant, ledit moyen de résistance intégré étant en outre adapté pour détecter ou induire des déformations du micro-cantilever, la puce comprenant en outre une portion essentiellement rigide comprenant une paire de fils intégrée étant au moins en partie encapsulée dans un corps électriquement isolant, la section de rattachement du micro-cantilever étant rattachée à la portion essentiellement rigide de manière à ce que ladite paire de fils intégrée soit connectée au moyen de résistance intégré et soit électriquement accessible par le biais d'un terminal de contact sur une partie de surface extérieure de la portion essentiellement rigide, la puce étant **caractérisée en ce que** le polymère est un polymère photosensible, et **en ce que** ledit moyen de résistance intégré présente une structure en méandres comprenant des premières sections les plus longues connectées par des deuxièmes sections les plus courtes, les premières sections les plus longues s'étendant en parallèle le long de la forme rectangulaire du micro-cantilever dans une direction normale à la section de rattachement.

2. Puce selon la revendication 1, dans laquelle le polymère photosensible est choisi dans le groupe constitué par : les polymères à base de SU-8, tel qu'un polymère XP SU-8, les polyimides ou les polymères de cyclotène BCB.

3. Puce selon la revendication 2, dans laquelle le corps flexible à base de polymère comprend une première et une deuxième couches de polymère, les première et deuxième couches de polymère étant arrangées dans une structure en sandwich.

4. Puce selon la revendication 3, dans laquelle le moyen de résistance intégré est au moins en partie encastré entre la première et la deuxième couche de polymère.

5. Puce selon l'une quelconque des revendications précédentes, dans laquelle le moyen de résistance intégré comprend plus d'une résistance, la résistance électrique de la plus d'une résistance étant une fonction des déformations de la structure flexible.

6. Puce selon la revendication 5, dans laquelle la plus d'une résistance est définie par un matériau semiconducteur, tel que du silicone.

7. Puce selon la revendication 1, dans laquelle la portion essentiellement rigide comprend une première et une deuxième couches de polymère, et dans laquelle le conducteur électrique intégré est au moins en partie encastré entre la première et la deuxième couche de polymère de la portion essentiellement rigide.

8. Puce selon la revendication 7, dans laquelle les couches de polymère de la portion essentiellement rigide sont formées dans des couches de polymère photosensible, le polymère photosensible étant choisi dans le groupe constitué par : les polymères à base de SU-8, tel qu'un polymère XP SU-8, les polyimides ou les polymères de cyclotène BCB.

9. Puce selon les revendications 7 ou 8, dans laquelle le conducteur électrique intégré comprend un matériau semiconducteur, tel que du silicone.

10. Puce selon l'une quelconque des revendications 7 à 9, comprenant en outre au moins trois résistances, les au moins trois résistances formant une partie de la portion essentiellement rigide de la puce.

11. Puce selon la revendication 10, comprenant trois résistances.

12. Puce selon la revendication 11, dans laquelle les trois résistances sont au moins en partie encastrées entre la première et la deuxième couche de polymère de la portion essentiellement rigide.

13. Puce comprenant deux structures flexibles selon l'une quelconque des revendications 5 ou 6, la puce comprenant en outre une portion essentiellement rigide comprenant des conducteurs électriques intégrés, chacun étant au moins en partie encapsulé dans un corps électriquement isolant, un nombre desdits conducteurs électriques intégrés étant connecté au moyen de détection intégré et étant électriquement accessible par le biais de terminaux de contact sur une partie de surface extérieure de la portion essentiellement rigide.

14. Puce selon la revendication 13, comprenant en outre deux résistances, les deux résistances formant une partie de la portion essentiellement rigide de la puce.

15. Puce selon la revendication 14, dans laquelle la portion essentiellement rigide comprend une première et une deuxième couches de polymère, et dans laquelle les conducteurs électriques intégrés et les deux résistances sont au moins en partie encastrés entre la première et la deuxième couche de polymère de la portion essentiellement rigide de la puce.

16. Puce selon les revendications 14 ou 15, dans laquelle les deux structures flexibles comprennent chacune une résistance et dans laquelle la portion essentiellement rigide de la puce comprend deux résistances de telle sorte que la puce comprend un total de quatre résistances, et dans laquelle les quatre résistances sont connectées de manière à former un pont de Wheatstone.

17. Puce selon l'une quelconque des revendications 7 à 16, comprenant en outre un substrat à base de polymère soutenant la portion essentiellement rigide de la puce.

18. Puce selon la revendication 17, dans laquelle le substrat est formé dans un polymère photosensible, le polymère photosensible étant choisi dans le groupe constitué par : les polymères à base de SU-8, tel qu'un polymère XP SU-8, les polyimides ou les polymères de cyclotène BCB.

19. Puce selon l'une quelconque des revendications 7 à 16, comprenant en outre un substrat à base de silicone soutenant la portion essentiellement rigide de la puce.

20. Procédé de fabrication d'une puce, le procédé comprenant les étapes consistant à

   - fournir une première couche électriquement isolante,
   - mouler la première couche électriquement isolante de manière à former une première surface et une deuxième surface différente, où la deuxième surface forme une première partie d'un cantilever flexible présentant une forme rectangulaire, au moins un côté de la forme rectangulaire étant une section de rattachement rattachant la deuxième surface à la première surface,
   - fournir, sur la première surface de la couche, une première couche conductrice, et à mouler la première couche conductrice de manière à former une paire de fils sur la première surface de la première couche électriquement isolante moulée,
   - fournir, sur la deuxième surface, une deuxième couche conductrice, et à mouler la deuxième couche conductrice de manière à former au moins une résistance sur la deuxième surface de la première couche électriquement isolante moulée où la paire de fils est connectée électriquement à la au moins une résistance, et
   - fournir, sur les première et deuxième surfaces de la première couche électriquement isolante, une deuxième couche électriquement isolante de manière à encapsuler au moins en partie la paire de fils et la au moins une résistance, et formant ainsi une deuxième partie du cantilever flexible,

   **caractérisé en ce que** la résistance étant une structure allongée en méandres comprenant des premières sections les plus longues connectées par des deuxièmes sections les plus courtes, les premières sections les plus longues étant arrangées en parallèle le long de la longueur de la forme rectangulaire du cantilever flexible dans une direction normale à la section de rattachement, et **en ce que** le procédé comprend en outre les étapes consistant à fournir une troisième couche sur la deuxième couche électriquement isolante, et à mouler la troisième couche de manière à former un substrat qui soutienne seulement la première surface de la deuxième couche électriquement isolante.

21. Procédé selon la revendication 20, dans lequel au moins un conducteur sur la première surface est connecté à au moins une résistance sur la deuxième surface.

22. Procédé selon les revendications 20 ou 21, dans lequel les couches électriquement isolantes sont des couches de polymères.

23. Procédé selon la revendication 22, dans lequel les couches de polymère sont formées dans des couches de polymère photosensible, le polymère photosensible étant choisi dans le groupe constitué par : les polymères à base de SU-8, tel qu'un polymère XP SU-8, les polyimides ou les polymères de cyclotène BCB.

24. Procédé selon la revendication 20, dans lequel la troisième couche est formée dans une couche de polymère photosensible, le polymère photosensible étant choisi dans le groupe constitué par : les polymères à base de SU-8, tel qu'un polymère XP SU-8, les polyimides ou les polymères de cyclotène BCB.

25. Procédé selon la revendication 20, dans lequel la troisième couche est une couche à base de silicone.

26. Procédé selon la revendication 20, comprenant en outre les étapes consistant à

- fournir une couche sacrificielle sur une pastille de silicone, sur laquelle la première couche électriquement isolante est fournie, et
- retirer la pastille de silicone après avoir fourni et moulé la troisième couche.

(a) — Cr/Au/Cr (50Å/500Å/200Å)
Si wafer

(b) — SU-8 top layer (1.8um)

(c) — Au metal wires (1um)

(d) — Au resistors (400 Å)

(e) — SU-8 bottom layer (5.8um)

(f) — SU-8 substrate layer (350um)

(g) — Release of chips

Fig. 1

Fig. 2

Fig. 3

Fig. 4